# EUROPEAN PATENT APPLICATION

(11) **EP 4 546 401 A1**
(43) Date of publication of application: **30.04.2025**
(21) Application number: 23827220.7
(22) Date of filing: 21.06.2023
(51) Int. Cl.: H01L 21/60

(54) **BONDING WIRE FOR SEMICONDUCTOR DEVICES**

(30) Priority: 24.06.2022 JP 2022101612
(71) Applicant: NIPPON STEEL CHEMICAL & MATERIAL CO., LTD., Tokyo 103-0027 (JP); Nippon Micrometal Corporation, Iruma-shi Saitama 358-0032 (JP)
(72) Inventor: UNO, Tomohiro, Tokyo 100-8071 (JP); ODA, Daizo, Iruma-shi, Saitama 358-0032 (JP); ETO, Motoki, Iruma-shi, Saitama 358-0032 (JP)
(74) Representative: Vossius & Partner Patentanwälte Rechtsanwälte mbB
(86) International application number: PCT/JP2023/022861
(87) International publication number: WO 2023/249037

(57) **Abstract**

There is provided a novel Cu bonding wire for semiconductor devices that achieves a favorable shape stability of a 2nd bonded part. The bonding wire includes: a core material of Cu or a Cu alloy; and a coating layer containing a conductive metal other than Cu formed on a surface of the core material, wherein an average size of crystal grains in a wire circumferential direction, obtained by analyzing a surface of the wire by an electron backscattered diffraction (EBSD) method, is 35 nm or more and 140 nm or less, three or more elements selected from the group consisting of Pd, Pt, Au, Ni, and Ag are contained in a region (hereinafter, referred to as a "region d₀₋₁₀") from the surface to a depth of 10 nm in a concentration profile in a depth direction of the wire obtained by measurement using Auger electron spectroscopy (AES), and concentration conditions (i) and (ii) below are satisfied:
(i) for at least three elements out of the three or more elements contained in the region d₀₋₁₀, each element have an average concentration in the region d₀₋₁₀ of 5 atomic% or more, and
(ii) for all elements out of the three or more elements contained in the region d₀₋₁₀, each element have an average concentration in the region d₀₋₁₀ of 80 atomic% or less.

## Description

### TECHNICAL FIELD

The present invention relates to a bonding wire for semiconductor devices. Furthermore, the present invention relates to a semiconductor device including the bonding wire.

### BACKGROUND ART

In semiconductor devices, electrodes formed on a semiconductor chip are connected with electrodes on a lead frame or a substrate using a bonding wire. A bonding process for bonding wires is carried out by performing 1st bonding of a wire part onto an electrode on a semiconductor chip using a tubular bonding tool (capillary) for bonding by inserting a bonding wire therethrough; forming a loop; and finally performing 2nd bonding of a wire part onto the lead frame or an external electrode such as an electrode on the substrate. In the 1st bonding, a tip end of the wire part (hereinafter, also referred to as a "tail") emerging from the capillary is heated and melted by arc heat input to form a free air ball (FAB: Free Air Ball; hereinafter, also simply referred to as "ball") through surface tension, and then this ball part is compression-bonded (hereinafter, also referred to as "ball-bonded") onto the electrode on the semiconductor chip. In the 2nd bonding, the wire part is compression-bonded (hereinafter, also referred to as "wedge-bonded") onto the external electrode by applying ultrasonic waves and load from the capillary to the wire part without forming the ball. Then, the bonding process is followed by sealing the bonded parts with a sealing resin to obtain a semiconductor device.

Gold (Au) has been the common material of a bonding wire, but is being replaced with copper (Cu) mainly for LSI use (e.g., Patent Literatures 1 to 3). Meanwhile, regarding uses in on-vehicle devices with the background of recent proliferation of electric vehicles and hybrid vehicles, and further, for uses in power devices (power semiconductor device) in regards to large power equipment such as air conditioners and photovoltaic power generation systems, there has been a growing demand for replacement with Cu that has high efficiency and reliability due to its high thermal conductivity and fusing current characteristics.

Cu has the drawback of being more susceptible to oxidation than Au. As a method of preventing the surface oxidation of a Cu bonding wire, there has been proposed a structure in which a surface of a Cu core material is coated with a metal such as Pd (Patent Literature 4). There has also been proposed a Pd-coated Cu bonding wire which has an improved bond reliability of the 1st bonded part by coating a surface of a Cu core material with Pd and adding Pd and Pt into the Cu core material (Patent Literature 5).

### RELATED ART REFERENCE

### Patent Literature

Patent Literature 1: JP-A-S61-48534
Patent Literature 2: JP-T-2018-503743
Patent Literature 3: WO 2017/221770
Patent Literature 4: JP-A-2005-167020
Patent Literature 5: WO 2017/013796

### SUMMARY OF INVENTION

### PROBLEM TO BE SOLVED BY THE INVENTION

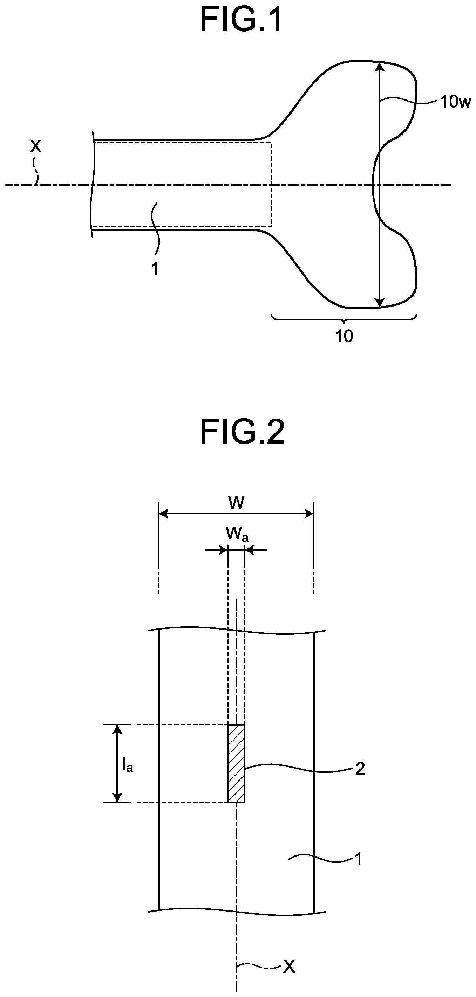

As described above, in the 2nd bonding, the wire part is compression-bonded onto the external electrode by applying ultrasonic waves and load from a capillary to the wire part. More specifically, the 2nd bonding includes stitch bonding, in which the wire is pressed onto the outer electrode at the tip end of a capillary to bond the wire to the external electrode, and tail bonding which is performed for the purpose of temporal bonding to form the tail as preparation for forming the FAB in the subsequent process. The wire temporal bonded part in the tail bonding is formed in correspondence to the wire supply opening edge at the tip end of the capillary, and the wire temporal bonded part is pulled off together with the tail when the length of the tail reaches a certain length. When the wire temporal bonded part in the tail bonding is pulled off from the wire compression-bonded part deformed by the stitch bonding in this manner, the 2nd bonded part formed on the external electrode has a fish tail shape (fish tail fin shape) (see FIG. 1; the 2nd bonded part is indicated by reference sign 10). In this regard, as external electrodes become finer pitched accompanied by size reduction and increase in numbers of pins of a semiconductor device, in regards to the bonding wire used in stably performing the 2nd bonding on small-area external electrodes disposed at a narrow pitch or used in stabilizing the size of the FAB formed in subsequent processes, as well as achieving favorable continuous bondability, shape stability of the 2nd bonded part, such as symmetry or dimensional stability of the above-described fish tail shape, is required to further improve.

On-vehicle devices and power devices tend to be exposed to higher temperatures as compared with general electronic devices during operation, and the bonding wire used therefor is required to exhibit a favorable bond reliability in a rigorous high-temperature environment. In regards to this point, it has been confirmed that, in a conventional Cu bonding wire having a Pd-coating layer, the Pd-coating layer may partially exfoliate during the connecting process of the wire, thereby causing exposure of the Cu core material, and as a result, a contact area between the Pd-coating part and the Cu-exposed part is exposed to an environment containing oxygen, water vapor, and sulfur compound-based outgas generated from a sealing resin under the high-temperature environment, resulting in local corrosion of Cu, that is, galvanic corrosion, which makes it difficult to sufficiently achieve the bond reliability of the 2nd bonded part.

First, an object of the present invention is to provide a novel Cu bonding wire that achieves a favorable shape stability of the 2nd bonded part.

Second, an object of the present invention is to provide a novel Cu bonding wire that achieves a favorable shape stability of the 2nd bonded part and also achieves a favorable bond reliability of the 2nd bonded part even in a rigorous high-temperature environment.

### MEANS FOR SOLVING PROBLEM

As a result of earnest investigation as to the problem described above, the present inventors have found that the problems described above can be solved by the bonding wire having the configurations described below, and completed the present invention.

That is, the present invention includes the following content.
[1] A bonding wire for semiconductor devices, the bonding wire comprising: a core material of Cu or a Cu alloy; and a coating layer containing a conductive metal other than Cu formed on a surface of the core material, wherein an average size of crystal grains in a wire circumferential direction, obtained by analyzing a surface of the wire by an electron backscattered diffraction (EBSD) method, is 35 nm or more and 140 nm or less, and three or more elements selected from the group consisting of Pd, Pt, Au, Ni, and Ag are contained in a region (hereinafter, referred to as a "region d₀₋₁₀") from the surface to a depth of 10 nm in a concentration profile in a depth direction of the wire obtained by measurement using Auger electron spectroscopy (AES), and concentration conditions (i) and (ii) below are satisfied:
   (i) for at least three elements out of the three or more elements contained in the region d₀₋₁₀, each element have an average concentration in the region d₀₋₁₀ of 5 atomic% or more, and
   (ii) for all elements out of the three or more elements contained in the region d₀₋₁₀, each element have an average concentration in the region d₀₋₁₀ of 80 atomic% or less.
[2] The bonding wire according to [1], wherein a thickness of the coating layer is 40 nm or more and 200 nm or less.
[3] The bonding wire according to [1] or [2], wherein a proportion of a <111> crystal orientation angled at 15 degrees or less to a longitudinal direction of the wire is equal to or higher than 30% and equal to or lower than 95% in results of measurement of the crystal orientation on the surface of the wire by the EBSD method.
[4] The bonding wire according to any one of [1] to [3], wherein the concentration profile in the depth direction of the wire is obtained by performing the measurement using AES under the following <Condition> while digging down the wire from its surface in the depth direction by Ar sputtering:
   <Condition> a center of width of the measuring surface is aligned with a center of width of the wire, the width of the measuring surface is 5% or more and 15% or less of a diameter of the wire, and a length of the measuring surface is five times the width of the measuring surface.
[5] The bonding wire according to any one of [1] to [4], wherein the bonding wire contains one or more elements selected from the group consisting of B, P, In, and Mg (hereinafter, referred to as a "first additive element"), and a total concentration of the first additive element is 1 ppm by mass or more and 100 ppm by mass or less relative to the entire wire.
[6] The bonding wire according to any one of [1] to [5], wherein the bonding wire contains one or more elements selected from the group consisting of Se, Te, As, and Sb (hereinafter, referred to as a "second additive element"), and a total concentration of the second additive element is 1 ppm by mass or more and 100 ppm by mass or less relative to the entire wire.
[7] The bonding wire according to any one of [1] to [6], wherein the bonding wire contains one or more elements selected from the group consisting of Ga, Ge, and Ag (hereinafter, referred to as a "third additive element"), and a total concentration of the third additive element is 0.011% by mass or more and 1.5% by mass or less relative to the entire wire.
[8] A semiconductor device comprising the bonding wire according to any one of [1] to [7].

### EFFECT OF THE INVENTION

The present invention can provide the novel Cu bonding wire that achieves a favorable shape stability of the 2nd bonded part.

Furthermore, the present invention can provide the novel Cu bonding wire that achieves a favorable shape stability of the 2nd bonded part and also achieves a favorable bond reliability of the 2nd bonded part even in a rigorous high-temperature environment.

### BRIEF DESCRIPTION OF DRAWINGS

FIG. 1 is a schematic view illustrating a 2nd bonded part.
FIG. 2 is a schematic view illustrating a position and dimensions of a measuring surface for measuring a width of crystal grains on a surface of a wire by an EBSD method or for performing a composition analysis using AES.
FIG. 3 is a schematic diagram of a concentration profile in a depth direction of a wire according to an embodiment of the present invention obtained by measuring the wire using AES.
FIG. 4 is a schematic diagram of a concentration profile in a depth direction of a wire according to an embodiment of the present invention obtained by measuring the wire using AES.
FIG. 5 is a schematic diagram of a concentration profile in a depth direction of a wire according to an embodiment of the present invention obtained by measuring the wire using AES.

### EMBODIMENT FOR CARRYING OUT THE INVENTION

Hereinafter, the present invention will be described in detail with reference to preferable embodiments thereof. Drawings may be referred to during the explanation. However, note that each drawing schematically shows the shape, size and arrangement of constituent elements only to the extent that the invention can be understood. The present invention is not limited to the following embodiments and examples and may be modified for implementation within the scope not departing from the scope of claims of the present invention and their equivalents.

### [Bonding wire for semiconductor devices]

A bonding wire for semiconductor devices according to the present invention (hereinafter, also simply referred to as a "wire of the present invention" or "wire") characterized in that the bonding wire includes:
a core material of Cu or a Cu alloy; and
a coating layer containing a conductive metal other than Cu formed on a surface of the core material, wherein
an average size of crystal grains in a wire circumferential direction, obtained by analyzing a surface of the wire by an electron backscattered diffraction (EBSD) method, is 35 nm or more and 140 nm or less, and
three or more elements selected from the group consisting of Pd, Pt, Au, Ni, and Ag are contained in a region (hereinafter, referred to as a "region d₀₋₁₀") from the surface to a depth of 10 nm in a concentration profile in a depth direction of the wire obtained by measurement using Auger electron spectroscopy (AES), and concentration conditions (i) and (ii) below are satisfied:
   (i) at least three elements out of the three or more elements contained in the region d₀₋₁₀ each have an average concentration in the region d₀₋₁₀ of 5 atomic% or more, and
   (ii) all elements out of the three or more elements contained in the region d₀₋₁₀ each have an average concentration in the region d₀₋₁₀ of 80 atomic% or less.

As described above, a 2nd bonded part formed on an external electrode has a fish tail shape (fish tail fin shape). FIG. 1 illustrates a schematic view when the 2nd bonded part formed on the external electrode is viewed from directly above in a direction perpendicular to the main surface of the external electrode. In FIG. 1, a 2nd bonded part 10 having a fish tail shape is formed on the right edge of a wire 1. To stably perform 2nd bonding on small-area external electrodes with a narrow pitch, and to achieve favorable continuous bondability, including stabilization of the size of the FAB formed in subsequent processes, it is preferable for the fish tail shape of the 2nd bonded part to exhibit good symmetry. Specifically, in FIG. 1, the axis of the wire is shown by a dashed line X extending in the left-right direction, and the fish tail shape of the 2nd bonded part preferably exhibits favorable symmetry to the axis of the wire. From the same viewpoint as above, the fish tail shape of the 2nd bonded part preferably exhibits favorable dimensional stability. Specifically, when performing multiple 2nd bonding continuously, it is preferable to achieve a fish tail shape in which the variation in the deformation length in the axis direction of the wire (the dimension in the left-right direction of the 2nd bonded part 10 in FIG. 1) and the deformation width in a direction perpendicular to the axis of the wire (a dimension 10w in the up-down direction of the 2nd bonded part 10 in FIG. 1) is small. In particular, for stably performing 2nd bonding on small-area external electrodes with a narrow pitch, it is particularly preferable to achieve a fish tail shape in which the variation in the deformation width in a direction perpendicular to the axis of the wire is small.

As a result of earnest investigation as to improve the shape stability of the 2nd bonded part such as symmetry and the dimensional stability of the fish tail shape, The present inventors have found that a favorable shape stability of the 2nd bonded part can be achieved with a bonding wire including a core material of Cu or a Cu alloy and a coating layer containing a conductive metal other than Cu formed on a surface of the core material, in which an average size of crystal grains in a wire circumferential direction, obtained by analyzing a surface of the wire by an EBSD method, is 35 nm or more and 140 nm or less, three or more elements selected from the group consisting of Pd, Pt, Au, Ni, and Ag are contained in a region from the surface to a depth of 10 nm in the concentration profile in the depth direction of the wire obtained by measurement using AES, and the above-described concentration conditions (i) and (ii) are satisfied. Furthermore, the present inventors have found that the bonding wire including a coating layer having the above-described specific configuration achieves a favorable bond reliability of the 2nd bonded part even when exposed to a rigorous high-temperature environment exceeding 175°C. In this manner, the present invention significantly contributes to size reduction and increase in number of pins of a semiconductor device and also significantly contributes to putting a Cu bonding wire into practical use and promotion in on-vehicle devices and power devices.

### <Core material of Cu or Cu alloy>

The wire of the present invention includes a core material of Cu or a Cu alloy (hereinafter, also simply referred to as "Cu core material").

The Cu core material is not particularly limited as long as it is made of Cu or Cu alloy, and there may be used a known Cu core material constituting a conventional Pd-coated Cu wire which has been known as a bonding wire for semiconductor devices.

In the present invention, the concentration of Cu in the Cu core material may be, for example, 97 atomic% or more, 97.5 atomic% or more, 98 atomic% or more, 98.5 atomic% or more, 99 atomic% or more, 99.5 atomic% or more, 99.8 atomic% or more, 99.9 atomic% or more, or 99.99 atomic% or more in the center (axial core part) of the Cu core material.

The Cu core material may contain one or more dopants selected from a first additive element, a second additive element, and a third additive element described later, for example. Preferable contents of these dopants are described later.

In a preferable embodiment, the Cu core material consists of Cu and inevitable impurities. In another preferable embodiment, the Cu core material consists of Cu; one or more elements selected from the first additive element, the second additive element and the third additive element described later; and inevitable impurities. The term "inevitable impurities" used in relation to the Cu core material encompasses elements constituting a coating layer described later.

### <Coating layer>

The wire of the present invention includes a coating layer containing conductive metal other than Cu (hereinafter, also simply referred to as a "coating layer") formed on a surface of the Cu core material.

From the viewpoint of achieving a favorable shape stability of the 2nd bonded part and also achieving a favorable bond reliability of the 2nd bonded part even in a rigorous high-temperature environment, it is important for the coating layer in the wire of the present invention to satisfy both the following conditions (1) and (2):
(1) an average size of crystal grains in a wire circumferential direction, obtained by analyzing a surface of the wire by the EBSD method, is 35 nm or more and 140 nm or less; and
(2) three or more elements selected from the group consisting of Pd, Pt, Au, Ni, and Ag are contained in a region (hereinafter, referred to as a "region d₀₋₁₀") from the surface to a depth of 10 nm in a concentration profile in a depth direction of the wire obtained by measurement using AES, and the following concentration conditions (i) and (ii) are satisfied:
   (i) at least three elements out of the three or more elements contained in the region d₀₋₁₀ each have an average concentration in the region d₀₋₁₀ of 5 atomic% or more, and
   (ii) all elements out of the three or more elements contained in the region d₀₋₁₀ each have an average concentration in the region d₀₋₁₀ of 80 atomic% or less.

### - Condition (1) -

The condition (1) relates to an average size of crystal grains in a wire circumferential direction ("width of crystal grains"), obtained by analyzing a surface of a wire by the EBSD method.

By including the coating layer that satisfies the condition (1) in combination with the condition (2), the wire of the present invention can achieve a favorable shape stability of the 2nd bonded part, and further a favorable bond reliability of the 2nd bonded part even in a rigorous high-temperature environment. The crystal grains on the wire surface form an elongated structure in the wire longitudinal direction. According to the work of the present inventors, it has been found that reducing the width of crystal grains, which is the average size of the crystal grains in the wire circumferential direction, to a certain range is effective in improving the shape stability and the bond reliability of the 2nd bonded part. As a comparison, it has been confirmed that it is difficult to improve the shape stability and the bond reliability of the 2nd bonded part by controlling the average length of crystal grains in the wire longitudinal direction or the average particle size of crystal grains converted by an equivalent circle.

Regarding the condition (1), from the viewpoint of achieving a good shape stability of the 2nd bonded part, in particular, achieving symmetry of the fish tail shape, the width of crystal grains which is obtained by analyzing the surface of the wire of the present invention by the EBSD method is 140 nm or less, preferably 135 nm or less, 130 nm or less or 125 nm or less, more preferably 120 nm or less or 110 nm or less, further preferably 100 nm or less, 95 nm or less or 90 nm or less. In particular, it is more preferable that the width of the crystal grains is 100 nm or less, as this makes it easier to achieve much better symmetry of the fish tail shape. Further, the present inventors have confirmed that a favorable bond reliability of the 2nd bonded part can be easily achieved even in a rigorous high-temperature environment when the width of the crystal grains falls within the range described above.

From the viewpoint of achieving a good shape stability of the 2nd bonded part, in particular, achieving symmetry of the fish tail shape, the lower limit of the width of the crystal grains is 35 nm or more, preferably 40 nm or more, 42 nm or more or 44 nm or more, more preferably 45 nm or more, 46 nm or more, 48 nm or more, 50 nm or more, 52 nm or more, 54 nm or more or 55 nm or more. In particular, it is more preferable that the width of the crystal grains is 45 nm or more, as this makes it easier to achieve much better symmetry of the fish tail shape. Further, the present inventors have confirmed that a favorable bond reliability of the 2nd bonded part can be easily achieved even in a rigorous high-temperature environment when the width of the crystal grains falls within the above-described range.

The width of the crystal grains on the surface of the wire in the condition (1) can be determined by analyzing the surface of the wire by an Electron Backscattered Diffraction (EBSD) method. The device used for the EBSD method includes a scanning electron microscope and a detector attached thereto. In the EBSD method, a diffraction pattern of reflected electrons generated by irradiating a sample with an electron beam is projected onto the detector, and the diffraction pattern is analyzed to determine the crystal orientation at each measurement point. For analyzing data obtained by the EBSD method, an analysis software (OIM analysis manufactured by TSL Solutions, for example) can be used.

In measuring the width of the crystal grains on the wire surface by the EBSD method, a position and dimensions of a measuring surface are determined as follows. In the following description, the width of the measuring surface indicates the dimension of the measuring surface in a direction perpendicular to a wire axis (a thickness direction of the wire, a wire circumferential direction), and the length of the measuring surface indicates the dimension of the measuring surface in a direction along the wire axis (a length direction of the wire, a wire longitudinal direction).

First, the bonding wire to be measured is fixed to the sample holder in a linear arrangement. Next, the measuring surface is determined so that the center of width of the wire in a direction perpendicular to the wire axis is aligned with the center of width of the measuring surface, and the width of the measuring surface is 20% or more and 40% or less of the diameter of the wire. The length of the measuring surface may be set to be two to five times the width of the measuring surface. By determining the position and dimensions of the measuring surface as described above, it is possible to suppress the effect of the curvature of the wire surface, and to accurately measure and determine the success or failure of the condition (1), which is preferable for achieving a favorable shape stability and bond reliability of the 2nd bonded part. Note that the measurement is preferably performed in that the measurement magnification is in a range of 5,000 to 20,000 times, and the measurement point interval is in a range of 0.02 to 0.05 µm.

A further description will be given with reference to FIG. 2. FIG. 2 is a schematic plan view illustrating a wire 1 in which the direction of the wire axis (the length direction of the wire) corresponds to the vertical direction (up-down direction) of FIG. 2 and the direction perpendicular to the wire axis (the thickness direction of the wire) corresponds to the horizontal direction (left-right direction) of FIG. 2. FIG. 2 shows a measuring surface 2 in relation to the wire 1. The width of the measuring surface 2 is represented by a dimension wₐ of the measuring surface in the direction perpendicular to the wire axis, and the length of measuring surface 2 is represented by a dimension lₐ of the measuring surface in the direction of the wire axis. Note that the meanings of "the width of the measuring surface" and "the length of the measuring surface" in relation to the measuring surface are the same as those used in the analysis using AES in the condition (2) described later. Thus, in the analysis by the EBSD method, the measuring surface 2 is determined so that the center of width of the measuring surface 2 is aligned with the dashed line X, which indicates the center of width of the wire, and the width wₐ of the measuring surface is determined to be 20% or more and 40% or less of the diameter of the wire (the same value as the width W of the wire), that is, 0.2W or more and 0.4W or less. The length lₐ of the measuring surface satisfies the relation of 2wₐ ≤ lₐ ≤ 5wₐ.

For measuring the width of crystal grains on a wire surface by the EBSD method, in order to avoid the effects of stains, deposits, irregularities, scratches and the like on the wire surface, only the crystal orientations that can be identified on the basis of a certain degree of reliability in the measuring surface are used. A portion where crystal orientation cannot be measured or a portion where the degree of reliability in orientation analysis is low even when crystal orientation can be measured, and the like are excluded for calculation. For example, when OIM analysis manufactured by TSL Solutions is used as an analysis software, it is preferable that the analysis is performed excluding measurement points having C1 (Confidence Index) values of less than 0.1. If the data to be excluded exceeds, for example, 30% of the total, it is highly possible that there has been some kind of contamination in the measurement object. Thus, the measurement needs to be performed again from the process of the preparation of the measurement sample. The term "crystal grains on the wire surface" as used herein refers to not only crystal grains exposed on the wire surface but also crystal grains recognized as crystal grains by the EBSD measurement.

Further, when measuring the width of the crystal grains on the wire surface by the EBSD method, it is preferable that a boundary where the orientation difference between adjacent measurement points is 5 degrees or more is regarded as a crystal grain boundary to determine the width of the crystal grains. The calculation of the width of the crystal grains on the wire surface by the analysis software is generally performed by (i) drawing a line in the width direction (wire circumferential direction) of the measuring surface, determining the size of each crystal grain in the wire circumferential direction on the basis of an interval of the crystal grain boundaries on the line, and (ii) calculating the average size of the crystal grains in the wire circumferential direction by arithmetically averaging the sizes of respective crystal grains in the wire circumferential direction. This is performed for a plurality of lines (N number is preferably 10 or more, more preferably 20 or more) spaced apart from one another in the wire longitudinal direction, and the average value thereof is adopted as the width of the crystal grains.

The width of the crystal grains on the wire surface in the condition (1) is based on a result of the measurement under the conditions described in the section [Crystal analysis of wire surface by electron backscattered diffraction (EBSD) method] described later.

### - Condition (2) -

The condition (2) relates to a composition of the region from the wire surface to the depth of 10 nm in a concentration profile in the depth direction of the wire (hereinafter, also simply referred to as "concentration profile in the depth direction") obtained by measuring with AES.

By including the coating layer that satisfies the condition (2) in combination with the condition (1), the wire of the present invention can achieve a favorable shape stability of the 2nd bonded part. Furthermore, the wire of the present invention can achieve a favorable bond reliability of the 2nd bonded part even in a rigorous high-temperature environment.

Although the reason for exhibiting such an effect is not sure, it is considered that, in the Cu-based bonding wire including a coating layer containing three or more elements selected from the group consisting of Pd, Pt, Au, Ni, and Ag in a specified concentration range in a region from the surface to the depth of 10 nm, when the width of the crystal grains in the wire surface is reduced to fall within a certain range, it is considered that the synergetic action of the alloy composition and the fine crystal grains on the surface can improve the sliding properties between the capillary and the wire surface, suppress the breakage of the coating layer, and achieve uniform compressive deformation, and further that the symmetry in the fish tail shape with respect to the wire axis and dimensional stability of the fish tail shape are improved. In addition, it is considered that the bond reliability of the 2nd bonded part can be improved by suppressing the breakage of the coating layers due to the same action so that generation of corrosion under a high-temperature environment can be suppressed. In this regard, in a case that the elements contained in the region from the surface to the depth of 10 nm in addition to the coating layer containing only Pd are two or less, or a case that the region does not contain three or more elements selected from the group consisting of Pd, Pt, Au, Ni, and Ag even if the region contains three or more elements, it has been confirmed that the shape stability and the bond reliability of the 2nd bonded part is not improved even if the width of the crystal grains is reduced to a certain range (particularly the shape stability of the 2nd bonded part). Further, it has been cleared that the above-mentioned effects exhibited when reducing the width of the crystal grains to a certain range are specifically exhibited in the Cu-based bonding wire including a coating layer having a specific surface composition.

In the present invention, for obtaining the concentration profile in the depth direction of the wire using AES, it is preferable that measurement is performed so that the measurement points in the depth direction are 10 points or more and 20 points or less in the region from the wire surface to the depth of 10 nm. Accordingly, it is possible to accurately measure and determine the success or failure of the condition (2), which is preferable for achieving a favorable shape-stability and bond reliability of the 2nd bonded part. Therefore, in a preferable embodiment, the coating layer in the wire of the present invention satisfies the condition (2) described above in the concentration profile of the wire in the depth direction, which is obtained by measuring so that the measurement points in the depth direction using AES becomes 10 points or more and 20 points or less in the region from the surface of the wire to the depth of 10 nm.

Regarding the condition (2), from the viewpoint of achieving a favorable shape stability of the 2nd bonded part, in particular, a fish tail shape having a small variation in deformation width in a direction perpendicular to the wire axis, the region from the surface of the wire to the depth of 10 nm ("region d₀₋₁₀") in the concentration profile in the depth direction of the wire includes three or more elements selected from the group consisting of Pd, Pt, Au, Ni, and Ag. The present inventors have confirmed that the shape stability of the 2nd bonded part tends to be inferior in a case that the elements contained in the region d₀₋₁₀ are two or less, or the region d₀₋₁₀ does not contain three or more elements selected from the group consisting of Pd, Pt, Au, Ni, and Ag even if the region d₀₋₁₀ contains three or more elements.

In addition, regarding the condition (2), from the viewpoint of achieving a favorable shape stability of the 2nd bonded part, in particular, a fish tail shape having a small variation in deformation width in a direction perpendicular to the wire axis, three or more elements selected from the group consisting of Pd, Pt, Au, Ni, and Ag contained in the region d₀₋₁₀ satisfy the following concentration conditions (i) and (ii):
(i) Regarding at least three elements out of the three or more elements contained in the region d₀₋₁₀, the average concentration of each of the elements in the region d₀₋₁₀ is 5 atomic% or more, and
(ii) Regarding all of the three or more elements contained in the region d₀₋₁₀, the average concentration of each of the elements in the region d₀₋₁₀ is 80 atomic% or less.

Regarding the concentration condition (i), the average concentration of each of the elements in the region d₀₋₁₀ for at least three elements out of the three or more elements contained in the region d₀₋₁₀ is 5 atomic% or more, preferably 6 atomic% or more or 8 atomic% or more, more preferably 10 atomic% or more, 12 atomic% or more, 14 atomic% or more or 15 atomic% or more. In particular, it is preferable that the average concentration of each of the elements in the region d₀₋₁₀ for at least three elements out of the three or more elements contained in the region d₀₋₁₀ is 10 atomic% or more, as this makes it easier to achieve a fishtail shape having a smaller variation in deformation width in the direction perpendicular to the axis of the wire. Moreover, the present inventors have confirmed that it is easy to achieve a favorable bond reliability of the 2nd bonded part even in a rigorous high-temperature environment.

As described above, it is important that the average concentration of each of the elements in the region d₀₋₁₀ for at least three elements out of the three or more elements contained in the region d₀₋₁₀ is 5 atomic% or more. Examples of the modes satisfying the concentration condition (i) may include the following (a) to (c), and the advantageous effects of the present invention can be obtained in any of the modes.
(a) The average concentration of each of the elements in the region d₀₋₁₀ for all of the elements out of the three or more elements contained in the region d₀₋₁₀ is 5 atomic% or more (the preferable range of the average concentration is as described above).
(b) The average concentration of each of the elements in the region d₀₋₁₀ for three elements out of the three or more elements contained in the region d₀₋₁₀ is 5 atomic% or more (the preferable range of the average concentration is as described above), and the average concentration of each of the elements in the region d₀₋₁₀ for another or two elements is less than 5 atomic%.
(c) The average concentration of each of the elements in the region d₀₋₁₀ for four elements out of the three or more elements contained in the region d₀₋₁₀ is 5 atomic% or more (the preferable range of the average concentration is as described above), and the average concentration of each of the elements in the region d₀₋₁₀ regarding the other element is less than 5 atomic%.

Herein, the mode (a) corresponds to a case where the region d₀₋₁₀ contains 3 to 5 elements selected from the group consisting of Pd, Pt, Au, Ni, and Ag, the mode (b) corresponds to a case where the region d₀₋₁₀ contains 4 or 5 elements, and the mode (c) corresponds to a case where the region d₀₋₁₀ contains 5 elements.

Regarding the concentration condition (ii), the average concentration of each of the elements in the region d₀₋₁₀ for all of the elements out of the three or more elements contained in the region d₀₋₁₀ is 80 atomic% or less, preferably 75 atomic% or less, 74 atomic% or less or 72 atomic% or less, more preferably 70 atomic% or less, 68 atomic% or less, 66 atomic% or less or 65 atomic% or less. In particular, it is preferable that the average concentration of each of the elements in the region d₀₋₁₀ is 70 atomic % or less, as this makes it easy to achieve a fish tail shape having a much smaller variation in the deformation width in the direction perpendicular to the axis of the wire. Moreover, the present inventors have confirmed that it is easy to achieve a favorable bond reliability of the 2nd bonded part even in a rigorous high-temperature environment.

The composition of the region d₀₋₁₀ in the condition (2) can be confirmed and determined by performing composition analyses using AES while digging down from the surface of the wire in the depth direction (the direction toward the center of the wire) by Ar sputtering. Specifically, a change in concentration of each element in the direction from the surface of the wire toward the depth (center) of the wire (so-called a concentration profile in the depth direction) is obtained by performing 1) a composition analysis of the wire surface, and then repeating 2) a sputtering process with Ar and 3) a surface composition analysis after the sputtering treatment, and the above factors can be confirmed and determined on the bases of the concentration profile. In the present invention, for obtaining the concentration profile in the depth direction, the units of depth was in terms of SiO₂. Herein, when performing the composition analysis using AES, a gas component such as carbon (C), sulfur (S), oxygen (O) and nitrogen (N), non-metal elements, and the like is not considered.

When performing 1) the composition analysis of the wire surface and 3) the surface composition analysis after sputtering treatment, a position and dimensions of a measuring surface are determined as follows.

First, the bonding wire to be measured is fixed to the sample holder in a linear arrangement. Next, a measuring surface is determined so that the center of the width of the wire in a direction perpendicular to the wire axis is aligned with the center of the width of the measuring surface, and the width of the measuring surface is 5% or more and 15% or less of the diameter of the wire. The length of the measuring surface is set to be five times the width of the measuring surface. The measuring surface will be further described with reference to FIG. 2. As described above, in FIG. 2, the width of the wire is indicated by sign W, and the center of the width of the wire is indicated by a dashed line X. Thus, the measuring surface 2 is determined so that the center of width of the measuring surface 2 is positioned to be aligned with the dashed line X indicating the center of the width of the wire, and the width wₐ of the measuring surface is 5% or more and 15% or less of the diameter of the wire (the same value as the width W of the wire), that is, 0.05W or more and 0.15W or less. Further, the length lₐ of the measuring surface satisfies the relation of lₐ = 5wₐ. By determining the position and dimensions of the measuring surface as described above, it is possible to accurately measure the success or failure of the condition (2), which is preferable for achieving a favorable shape stability and a favorable bond reliability of the 2nd bonded part.

In the present invention, for improving the accuracy of the composition analysis using AES in obtaining a concentration profile in the depth direction of the wire, it is preferable to fix a peak used for detecting each of the elements of Pd, Pt, Au, Ni, Ag, and Cu. That is, as an energy value of a negative peak (minimum value) of each of the elements in a differential spectrum of Auger electron (hereinafter, referred to as an "Auger electron spectrum"), it is desirable to use the peak of Au (2022 eV), Pd (333 eV), Pt (1969 eV), Ag (359 eV), Ni (849 eV), or Cu (922 eV) (source of energy value: data installed in electron spectrum data analysis software "MultiPak" manufactured by Ulvac-Phi, Inc.).

In the Auger electron spectral analysis, a linear least squares treatment (LLS treatment) can be performed as needed. By this treatment, an element concentration can be quantified more accurately. For example, when energy values are close to each other, and peaks superimpose each other, like Cu and Ni, the LLS treatment is preferably performed when separating the superimposing peak components. Further, when the effect of background noise is relatively high, such as when Au or Pt is contained at a low concentration, the LLS treatment is preferably performed for reducing the background noise. The Auger electron spectral analysis can be performed using, for example, an analysis software (MultiPak) equipped with an AES device manufactured by Ulvac-Phi, Inc.

Then, in the obtained concentration profile in the depth direction, by focusing on the concentration C_{Pd} (atomic%) of Pd, the average concentration of Pd in the region d₀₋₁₀ can be obtained with an arithmetic average of the values of C_{Pd} for all measurement points in a region (i.e., a region d₀₋₁₀) from the wire surface position to a depth position of 10 nm. In the same manner, by focusing on the concentration C_{Pt} (atomic %) of Pt, the average concentration of Pt in the region d₀₋₁₀ can be obtained with an arithmetic average of the values of C_{Pt} for all measurement points of the region d₀₋₁₀. For the average concentration of each of the elements of Au, Ni, and Ag, the average concentration of each of the elements in the region d₀₋₁₀ is determined by obtaining an arithmetic average of the concentration values of each of the elements for all measurement points of the region d₀₋₁₀ in the same manner as above. When three or more elements from Pd, Pt, Au, Ni, and Ag are contained in the region d₀₋₁₀, and the concentration conditions (i) and (ii) described above are satisfied, it is determined that the condition (2) is satisfied. Further, it is preferable to obtain a concentration profile for measuring surfaces at a plurality of points (n ≥ 3) which are separated from each other by 1 mm or more in the direction of the wire axis, and employ an arithmetic average value thereof.

The existence and average concentration of each of the elements in the condition (2) are based on a result of the measurement under the conditions described in the section [Thickness analysis of coating layer by Auger electron spectroscopy (AES)] described later.

From the viewpoint of further obtaining the effects of the present invention, the average value of C_{Pd} + C_{Pt} + C_{Au} + C_{Ni} + C_{Ag} that is a sum of the concentration C_{Pd} (atomic%) of Pd, the concentration C_{Pt} (atomic%) of Pt, the concentration C_{Au} (atomic%) of Au, the concentration C_{Ni} (atomic%) of Ni, and the concentration C_{Ag} (atomic%) of Ag for measurement points in the region d₀₋₁₀ is preferably 70 atomic% or more, more preferably 80 atomic% or more, 85 atomic% or more or 90 atomic% or more, and further preferably 92 atomic% or more, 94 atomic% or more, 95 atomic% or more, 96 atomic% or more, 98 atomic% or more or 99 atomic% or more. The upper limit thereof may be 100 atomic%.

The average value of the sum C_{Pd} + C_{Pt} + C_{Au} + C_{Ni} + C_{Ag} can be determined based on the obtained concentration profile in the depth direction by, for example, obtaining an arithmetic average of the values of the sum C_{Pd} + C_{Pt} + C_{Au} + C_{Ni} + C_{Ag} for all measurement points in the region d₀₋₁₀ or obtaining a sum of the values of the average concentrations for the respective elements of Pd, Pt, Au, Ni, and Ag in the region d₀₋₁₀ determined as described above.

### - Other preferable conditions for coating layer -

In the wire of the present invention, it is more preferable that the coating layer satisfies, in addition to the conditions (1) and (2) described above, one or both of the following conditions (3) and (4):
(3) the thickness of the coating layer is 40 nm or more and 200 nm or less, and
(4) the proportion of a <111> crystal orientation angled at 15 degrees or less to the longitudinal direction of the wire is equal to or higher than 30% or more and equal to or lower than 95% in the results of the measurement of the crystal orientation on the surface of the wire by the EBSD method.

### - Condition (3) -

The condition (3) relates to the thickness of the coating layer.

In addition to the conditions (1) and (2), by including a coating layer that satisfies the condition (3), the wire of the present invention can achieve a further favorable bond reliability of the 2nd bonded part even in a rigorous high-temperature environment.

Regarding the condition (3), from the viewpoint of achieving a favorable bond reliability of the 2nd bonded part in a high-temperature environment, the thickness of the coating layer (a calculation method based on the concentration profile in the depth direction of the wire will be described later) is preferably 40 nm or more, more preferably 42 nm or more, 44 nm or more, 45 nm or more, 46 nm or more or 48 nm or more, more preferably 50 nm or more, 55 nm or more, 60 nm or more, 65 nm or more or 70 nm or more. The present inventors have confirmed that it is easy to achieve a further favorable bond reliability of the 2nd bonded part even in a rigorous high-temperature environment, in particular, when the thickness of the coating layer is 50 nm or more in combination with the conditions (1) and (2). Furthermore, from the viewpoint of achieving a favorable bond reliability of the 2nd bonded part in a high-temperature environment, the upper limit of the thickness of the coating layer is preferably 200 nm or less, more preferably 10 nm or less, 170 nm or less or 160 nm or less, further preferably 150 nm or less, 140 nm or less, 135 nm or less or 130 nm or less. The present inventors have confirmed that it is easy to achieve a further favorable bond reliability of the 2nd bonded part even in a rigorous high-temperature environment, in particular, when the thickness of the coating layer is 150 nm or less in combination with the conditions (1) and (2).

The thickness of the coating layer can be confirmed by performing composition analysis using AES while digging down the wire from its surface in the depth direction (direction to the center of the wire) by Ar sputtering, as described in relation to the condition (2). Specifically, a concentration profile in the depth direction is obtained by performing 1) a composition analysis of the wire surface, and then repeating 2) a sputtering process with Ar and 3) a surface composition analysis after the sputtering treatment, and the above factors can be confirmed from the concentration profile. The position and dimensions of the measuring surface in performing the composition analysis using AES are also as described in relation to the condition (2). By determining the position and dimensions of the measuring surface as described above, it is possible to accurately measure the success or failure of the condition (3), which is preferable for achieving a favorable bond reliability of the 2nd bonded part.

The thickness of the coating layer can be determined from the obtained concentration profile in the depth direction. First, a boundary between the Cu core material and the coating layer is determined based on the concentration of Cu. The position at which the concentration of Cu is 50 atomic % is determined as the boundary, and then a region where the concentration of Cu is 50 atomic % or more is determined to be the Cu core material and a region where the concentration of Cu is less than 50 atomic % is determined to be the coating layer. In the present invention, the boundary between the Cu core material and the coating layer is not necessarily a crystal grain boundary. The thickness of the coating layer can then be determined, by confirming the concentration profile from the wire surface toward the center of the wire, as a distance from a wire surface position Z0 to a depth position Z1 where the concentration of Cu as the core material reaches 50 atomic % for the first time. In the present invention, for determining the thickness of the coating layer based on the concentration profile in the depth direction, the unit for the depth was in terms of SiO₂. In addition, it is preferable to obtain a concentration profile for measuring surfaces at a plurality of points (n ≥ 3) which are separated from each other by 1 mm or more in the direction of the wire axis, and employ the arithmetic average value thereof.

The thickness of the coating layer in the condition (3) is based on a result of the measurement under the conditions described in the section [Thickness analysis of coating layer by Auger electron spectroscopy (AES)] described later.

### - Condition (4) -

The condition (4) relates to the proportion of a <111> crystal orientation angled at 15 degrees or less to the longitudinal direction of the wire in the measurement results of the crystal orientation on the surface of the wire by the EBSD method (hereinafter, simply referred to as the "proportion of <111> crystal orientation on wire surface").

As described above, the bonding process by the bonding wire is carried out by performing 1st bonding of a wire part onto an electrode on the semiconductor chip; forming a loop; and finally performing 2nd bonding of the wire part onto the lead frame or an external electrode such as an electrode on the electrode on the substrate. In addition to the conditions (1) and (2), by including the coating layer satisfying the condition (4), it is possible to provide a bonding wire that achieves stably forming a desired loop shape.

For the condition (4), from the viewpoint of realizing a wire exhibiting a favorable loop shape stability, the proportion of the <111> crystal orientation on the wire surface is preferably equal to or higher than 30%, more preferably equal to or higher than 35%, still more preferably equal to or higher than 40%, equal to or higher than 45%, equal to or higher than 50%, equal to or higher than 55% or equal to or higher than 60%, and the upper limit thereof is preferably equal to or lower than 95%, more preferably equal to or lower than 90%, still more preferably equal to or lower than 85%, equal to or lower than 84%, equal to or lower than 82% or equal to or lower than 80%. In particular, when the proportion of the <111> crystal orientation on the wire surface is in the range of equal to or higher than 40% and equal to or lower than 85%, it is possible to provide a bonding wire exhibiting exceptionally favorable loop shape stability.

The proportion of the <111> crystal orientation on the wire surface is obtained by measuring the crystal orientation on the wire surface by the EBSD method. The device and the analysis software used in the EBSD method are as described in relation to the above-described condition (1). Furthermore, it is as described above that the surface of the wire is used as the measuring surface, and the position and the dimensions of the measuring surface are also as described above. In addition, in the analysis, it is also as described in relation to the above-described condition (1) that only the crystal orientations that can be identified on the basis of a certain degree of reliability in the measuring surface are used and a portion where crystal orientation cannot be measured or a portion where the degree of reliability in orientation analysis is low even when crystal orientation can be measured, and the like are excluded from the calculation. In the present invention, it is preferable that the proportion of the <111> crystal orientation on the wire surface is obtained by performing the measurement for measuring surfaces at a plurality of points (n ≥ 3) which are separated from each other by 1 mm or more in the longitudinal direction of the wore, and employing an arithmetic average value thereof.

The proportion of the <111> crystal orientation on the wire surface tends to fall within a desired range by adjusting the composition of the coating layer, the processing degree of wire-drawing, heating conditions, and the like. Regarding the conditions for increasing the ratio of the <111> crystal orientation on the wire surface, in addition to adjusting the composition of the coating layer, if the composition is the same, for example, it is possible to adjust the conditions by increasing the processing rate, lowering the heating temperature, shortening the processing time, or the like.

The proportion of the <111> crystal orientation on the wire surface in the condition (4) is based on a result of the measurement under the conditions described in the section [Crystal analysis of wire surface by electron backscattered diffraction (EBSD) method] described later.

The coating layer may contain one or more dopants selected from the first additive element, the second additive element, and the third additive element described later, for example. Preferable contents of these dopants are described below.

In an embodiment, the coating layer consists of three or more elements selected from the group consisting of Pd, Pt, Au, Ni, and Ag; and inevitable impurities. In another embodiment, the coating layer consists of three or more elements selected from the group consisting of Pd, Pt, Au, Ni, and Ag; one or more elements selected from the first additive element, the second additive element, and the third additive element described later; and inevitable impurities. The term "inevitable impurities" used in relation to the coating layer encompasses elements constituting the Cu core material described above.

As described above, the wire of the present invention including the coating layer that satisfies the conditions (1) and (2) can achieve a favorable shape stability of the 2nd bonded part and also can achieve a favorable bond reliability of the 2nd bonded part even in a rigorous high-temperature environment. In addition to these conditions (1) and (2), when the coating layer satisfying the condition (3) is further included, it is possible to realize a wire exhibiting a further favorable bond reliability of the 2nd bonded part even in a rigorous high-temperature environment. In addition to these conditions (1) and (2), when the coating layer satisfying the condition (4) is further included, it is possible to realize a wire exhibiting a favorable loop shape stability.

As long as the wire of the present invention satisfies the conditions (1) and (2) described above, more preferably satisfies one or both of the conditions (3) and (4) described above in addition to the conditions (1) and (2) described above, the wire can exhibit the desired effects regardless of the composition in the region in a depth of exceeding 10 nm from the surface. In particular, from the viewpoint of further obtaining the effects of the present invention, when the thickness of the coating layer is defined as dt (nm) in the concentration profile in the depth direction of the wire, the total concentration of elements selected from the group consisting of Pd, Pt, Au, Ni, and Ag at the position in the depth dt(nm) from the wire surface, that is, at the boundary between the coating layer and the Cu core material is preferably 35 atomic % or more, more preferably 40 atomic % or more, 42.5 atomic % or more or 45 atomic % or more, still more preferably 46 atomic % or more, 47 atomic % or more, 47.5 atomic % or more, 48 atomic % or more, 49 atomic % or more or 49.5 atomic % or more, and the upper limit thereof may be 50 atomic %. Similarly, from the viewpoint of further obtaining the effects of the present invention, when the thickness of the coating layer is defined as dt (nm) in the concentration profile in the depth direction of the wire, the total concentration of elements selected from the group consisting of Pd, Pt, Au, Ni, and Ag at the position in the depth 0.5dt(nm) from the wire surface is preferably 70 atomic % or more, more preferably 80 atomic % or more, 85 atomic % or more or 90 atomic % or more, still more preferably 92 atomic % or more, 94 atomic % or more, 95 atomic % or more, 96 atomic % or more, 98 atomic % or more or 99 atomic % or more, and the upper limit thereof may be 100 atomic %

From the viewpoint of achieving a favorable shape stability of the 2nd bonded part, and from the viewpoint of achieving a favorable bond reliability of the 2nd bonded part even in a rigorous high-temperature environment, a concentration profile in the depth direction of the wire according to a particularly preferable embodiment will be shown below.

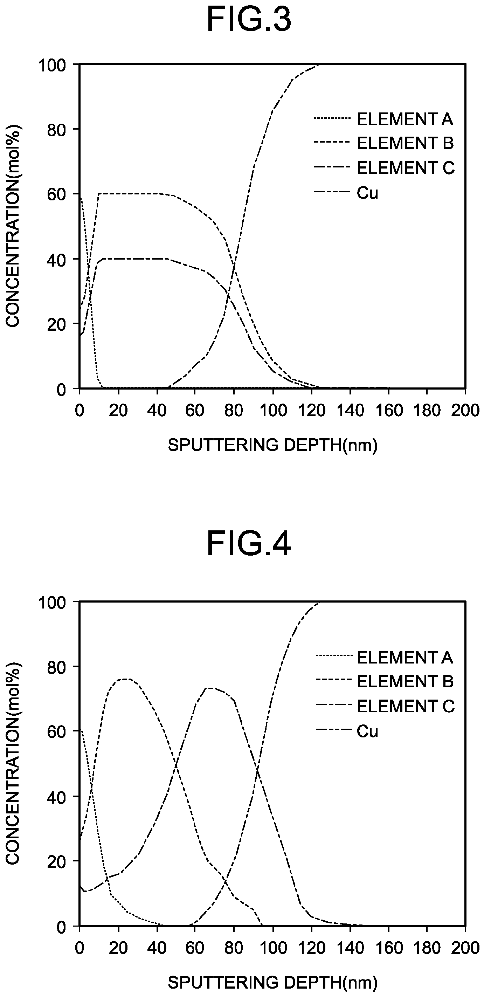

FIG. 3 is a schematic view of a concentration profile in the depth direction of a wire according to an embodiment of the present invention obtained by measuring the wire using AES. In the concentration profile in the depth direction shown in FIG. 3, regarding four elements including an element A, an element B, an element C, and Cu, the change in the concentration (mol % (atomic %); vertical axis) with respect to the sputtering depth (nm; horizontal axis) is schematically shown. Herein, each of the elements A, B, and C is an element selected from the group consisting of Pd, Pt, Au, Ni, and Ag. In the concentration profile in the depth direction shown in FIG. 3, from the surface of the wire (the position at the sputtering depth 0 nm) toward a very shallow position (for example, the position where the depth is 0.3dt, 0.25dt, 0.2dt or 0.15dt when the thickness of the coating layer is defined as dt), the concentration of the element A decreases and the concentrations of the element B and the element C increase. Furthermore, when the deeper positions in the depth direction are observed, the element B and the element C coexist at a predetermined ratio up to a predetermined depth position (for example, a position where the depth is 0.9dt, 0.8dt, 0.7dt or 0.6dt when the thickness of the coating layer is defined as dt). Further, when the deeper positions in the depth direction are observed, the concentrations of the element B and the element C decrease, and the concentration of Cu increases. Such a wire having the concentration profile in the depth direction may be formed by, for example, providing an alloy layer containing the element B and the element C at a predetermined ratio on the Cu core material, and further providing a layer of the element A thereon.

FIG. 4 is a schematic view of a concentration profile in the depth direction of a wire according to an embodiment of the present invention obtained by measuring the wire using AES. Similar to FIG. 3, also in the concentration profile in the depth direction shown in FIG. 4, regarding four elements including the element A, the element B, the element C, and Cu, the change in the concentration (mol % (atomic %); vertical axis) with respect to the sputtering depth (nm; horizontal axis) is schematically shown. Herein, each of the elements A, B, and C is an element selected from the group consisting of Pd, Pt, Au, Ni, and Ag. In the concentration profile in the depth direction shown in FIG. 4, from the surface of the wire (the position at the sputtering depth 0 nm) toward a very shallow position (for example, the position where the depth is 0.3dt, 0.25dt, 0.2dt or 0.15dt when the thickness of the coating layer is defined as dt), the concentration of the element A decreases and the concentrations of the element B and the element C increase. When the deeper positions in the depth direction are observed, the concentrations of the element B and the element C each become the maximum, and then the concentrations of the element B and the element C decrease and the concentration of Cu increases. The element B may show a maximum concentration at a certain depth position (d1) and may show a maximum over a certain depth range (d1 to d2). In addition, the element C may show a maximum concentration at a certain depth position (d3), and may show a maximum over a certain depth range (d3 to d4). Herein, d1, d2, d3, and d4 satisfy relations of d1 < d3 and d2 < d4. Also, d1 may satisfy, for example, 0.05dt < d1 < 0.9dt and 0.1dt < d1 < 0.8dt. For example, d3 may satisfy 0.05dt < d3 < 0.9dt and 0.1dt < d3 < 0.8dt. Such a wire having the concentration profile in the depth direction may be formed by, for example, providing a layer of the element C on the Cu core material, providing a layer of the element B thereon, and further providing a layer of the element A thereon.

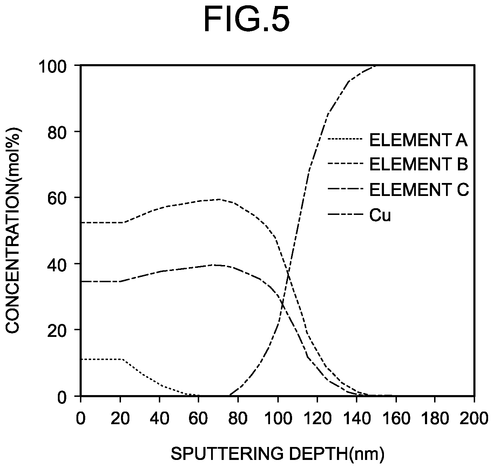

FIG. 5 is a schematic view of a concentration profile in the depth direction of a wire according to an embodiment of the present invention obtained by measuring the wire using AES. Similar to FIG. 3, also in the concentration profile in the depth direction shown in FIG. 5, regarding four elements including the element A, the element B, the element C, and Cu, the change in the concentration (mol % (atomic %); vertical axis) with respect to the sputtering depth (nm; horizontal axis) is schematically shown. Herein, each of the elements A, B, and C is an element selected from the group consisting of Pd, Pt, Au, Ni, and Ag. In the concentration profile in the depth direction shown in FIG. 5, from the surface of the wire (the position at the sputtering depth 0 nm) toward a constant shallow position (for example, the position where the depth is 0.9dt, 0.8dt, 0.7dt or 0.6dt when the thickness of the coating layer is defined as dt), the element A, the element B, and the element C coexist at a predetermined ratio. Furthermore, when the deeper positions in the depth direction are observed, the concentrations of the element A, the element B, and the element C decrease, and the concentration of Cu increases. Such a wire having the concentration profile in the depth direction may be formed by, for example, providing an alloy layer containing the element A, the element B, and the element C at a predetermined ratio on the Cu core material.

The composition in the region d₀₋₁₀ to be satisfied by the wire of the present invention is as described in relation to the condition (2). From the viewpoint of achieving a favorable shape stability of the 2nd bonded part, further, from the viewpoint of achieving a favorable bond reliability of the 2nd bonded part even in a rigorous high-temperature environment, it is more preferable that the element A in the concentration profiles in the depth direction shown in FIGS. 3 to 5 above is selected from the group consisting of Au, Pd, and Ag. From the same viewpoint, it is more preferable that the element B in the concentration profiles in the depth direction shown in FIGS. 3 to 5 is selected from the group consisting of Pd, Pt, Ni, and Ag, and it is more preferable that the element C is selected from the group consisting of Pd, Pt, and Ni. Thus, in a preferable embodiment, the wire of the present invention includes, in the concentration profile in the depth direction of the wire, the element A selected from the group consisting of Au, Pd, and Ag in a region from the surface to the depth of 10 nm, and further includes at least the element B selected from the group consisting of Pd, Pt, Ni, and Ag and the element C selected from the group consisting of Pd, Pt, and Ni (wherein the element A, the element B and the element C are elements that are different from one another). Furthermore, the average concentration of each of the elements of these elements A, B, and C falls within a range of 5 atomic% or more and 80 atomic% or less. Herein, the preferred value of the lower limit of the average concentration of each of the elements is as described above for the concentration condition (i), and the preferred value of the upper limit of the average concentration of each of the elements is as described above for the concentration condition (ii). In particular, from the viewpoint of achieving a particularly favorable shape stability of the 2nd bonded part, and also from the viewpoint of achieving a particularly favorable bond reliability of the 2nd bonded part even in a rigorous high-temperature environment, the wire of the present invention includes at least Au, Pd and Ni in the region from the surface to the depth of 10 nm in the concentration profile in the depth direction of the wire, and the average concentration of each of these Au, Pd and Ni falls within the range of 5 atomic % or more and 80 atomic % or less. In such an embodiment, it is preferable that Au as the element A, Pd or Ni as the element B, and Ni or Pd as the element C are contained.

Incidentally, in the concentration profiles in the depth direction shown in FIGS. 3 to 5 described above, regarding the four elements including the element A, the element B, the element C, and Cu, the changes in concentration with respect to the sputtering depth are shown. The wire of the present invention may contain other elements (for example, elements which are other than the element A to the element C and are selected from the group consisting of Pd, Pt, Au, Ni, and Ag, e.g., the first additive element, the second additive element, the third additive element, etc. to be described later), as long as satisfying the conditions (1) and (2) described above. Even when the wire contains elements other than the element A, the element B, the element C, and Cu, the success or failure of the condition (2) may be determined by focusing on the concentration of an element selected from the group consisting of Pd, Pt, Ni, and Ag.

The wire of the present invention may further contain one or more elements selected from the group consisting of B, P, In, and Mg ("first additive element"). When the wire of the present invention contains the first additive element, the total concentration of the first additive element is preferably 1 ppm by mass or more relative to the entire wire. This makes it possible to provide a bonding wire that achieves a more favorable compression-bonding shape of the 1st bonded part. The total concentration of the first additive element relative to the entire wire is more preferably 2 ppm by mass or more, and further preferably 3 ppm by mass or more, 5 ppm by mass or more, 8 ppm by mass or more, 10 ppm by mass or more, 15 ppm by mass or more or 20 ppm by mass or more. From the viewpoint of suppressing hardening of the wire and reducing chip damage at the time of 1st bonding, the total concentration of the first additive element is preferably 100 ppm by mass or less, and more preferably 90 ppm by mass or less, 80 ppm by mass or less, 70 ppm by mass or less, 60 ppm by mass or less or 50 ppm by mass or less. Accordingly, in a preferable embodiment, the wire of the present invention contains the first additive element, and the total concentration of the first additive element is 1 ppm by mass or more and 100 ppm by mass or less relative to the entire wire.

When the wire of the present invention contains the first additive element, the first additive element may be contained in either one of the Cu core material and the coating layer, or may be contained in both of them. The first additive element is preferably contained in the Cu core material from the viewpoint of providing a bonding wire that achieves a further favorable compression-bonding shape of the 1st bonded part.

The wire of the present invention may further contain one or more elements selected from the group consisting of Se, Te, As, and Sb ("second additive element"). When the wire of the present invention contains the second additive element, the total concentration of the second additive element is preferably 1 ppm by mass or more relative to the entire wire. This makes it possible to improve the bond reliability of the 1st bonded part in a high-temperature and high-humidity environment. The total concentration of the second additive element relative to the entire wire is more preferably 2 ppm by mass or more, and further preferably 3 ppm by mass or more, 5 ppm by mass or more, 8 ppm by mass or more, 10 ppm by mass or more, 15 ppm by mass or more or 20 ppm by mass or more. From the viewpoint of achieving a favorable compression-bonding shape of the 1st bonded part, the total concentration of the second additive element is preferably 100 ppm by mass or less, and further preferably 90 ppm by mass or less, 80 ppm by mass or less, 70 ppm by mass or less, 60 ppm by mass or less or 50 ppm by mass or less. Accordingly, in a preferable embodiment, the wire of the present invention contains the second additive element, and the total concentration of the second additive element is 1 ppm by mass or more and 100 ppm by mass or less relative to the entire wire.

When the wire of the present invention contains the second additive element, the second additive element may be contained in either one of the Cu core material and the coating layer, or may be contained in both of them. From the viewpoint of providing a bonding wire that achieves a further favorable bond reliability of the 1st bonded part in a high-temperature and high-humidity environment, the second additive element is preferably contained in the coating layer.

The wire of the present invention may further contain one or more elements selected from the group consisting of Ga, Ge, and Ag ("third additive element"). When the wire of the present invention contains the third additive element, the total concentration of the third additive element is preferably 0.011% by mass or more relative to the entire wire. This makes it possible to improve the bond reliability of the 1st bonded part in a high-temperature environment. The total concentration of the third additive element relative to the entire wire is more preferably 0.015% by mass or more, and more preferably 0.02% by mass or more, 0.025% by mass or more, 0.03% by mass or more, 0.031% by mass or more, 0.035% by mass or more, 0.04% by mass or more, 0.05% by mass or more, 0.07% by mass or more, 0.09% by mass or more, 0.1% by mass or more, 0.12% by mass or more, 0.14% by mass or more, 0.15% by mass or more or 0.2% by mass or more. From the viewpoint of achieving a favorable compression-bonding shape of the 1st bonded part, and from the viewpoint of achieving a favorable bondability of the 2nd bonded part, the total concentration of the third additive element is preferably 1.5% by mass or less, and more preferably 1.4% by mass or less, 1.3% by mass or less or 1.2% by mass or less. Accordingly, in a preferable embodiment, the wire of the present invention contains the third additive element, and the total concentration of the third additive element is 0.011% by mass or more and 1.5% by mass or less relative to the entire wire.

When the wire of the present invention contains the third additive element, the third additive element may be contained in either one of the Cu core material and the coating layer, or may be contained in both of them.

The contents of the first additive element, the second additive element, and the third additive element in the wire can be measured by the method described in [Measurement of element content] described later.

The diameter of the wire of the present invention is not particularly limited, and may be appropriately determined according to a specific purpose. The lower limit of the diameter may be, for example, 15 µm or more and 16 µm or more, and the upper limit of the diameter may be, for example, 80 µm or less, 70 µm or less, or 50 µm or less.

### < Manufacturing method for wire>

There will be described an example of a method for manufacturing the bonding wire for semiconductor devices according to the present invention.

First, raw material copper of high purity (4 N to 6 N; 99.99 to 99.9999% by mass or more) is processed into a large diameter (diameter of about 3 to 7 mm) by continuous casting to obtain an ingot.

In a case of adding a dopant such as the first additive element, second additive element, and third additive element described above, examples of an addition method therefor may include a method of causing the dopant to be contained in the Cu core material, a method of causing the dopant to be contained in the coating layer, a method of depositing the dopant on the surface of the Cu core material, and a method of depositing the dopant on the surface of the coating layer. These method may be combined with each other. The effect of the present invention can be achieved by employing any addition method. In the method of causing the dopant to be contained in the Cu core material, a copper alloy containing a required concentration of dopant may be used as a raw material to manufacture the Cu core material. In a case of obtaining such a copper alloy by adding the dopant to Cu as the raw material, a dopant component having high purity may be directly added to Cu, or alternatively, a mother alloy containing a dopant component at a concentration of about 1% may be used. In the method of causing the dopant to be contained in the coating layer, the dopant may be contained in a plating bath and the like of Pd, Pt, Au, Ni, or Ag at the time of forming the coating layer (in a case of wet plating), or in a target material (in a case of dry plating). In the method of depositing the dopant on the surface of the Cu core material and the method of depositing the dopant on the surface of the coating layer, at least one type of deposition treatment selected from (1) application of aqueous solution ⇒ drying ⇒ heat treatment, (2) a plating method (wet), and (3) a vapor deposition method (dry) may be performed on the surface of the Cu core material or the surface of the coating layer being as a deposition surface.

The ingot having a large diameter is subjected to forging, rolling, and wire-drawing to manufacture a wire containing Cu or a Cu alloy with a diameter of about 0.7 to 2.0 mm (hereinafter also referred to as an "intermediate wire").

As a method for forming the coating layer on the surface of the Cu core material, an electroplating, an electroless plating, a vapor deposition, and the like can be used. Among them, the electroplating is preferable industrially because it can stably control film thickness. For example, the coating layer may be formed on the surface of the ingot having a large diameter, or the coating layer may be formed on the surface of the intermediate wire, or the coating layer may be formed on the surface of the Cu core material after further thinning the intermediate wire by performing the wire-drawing (for example, after carrying out the wire-drawing to a final diameter of the Cu core material). In particular, since the width of crystal grains on the wire surface under the condition (1) described above is easily adjusted to be within a predetermined range, the coating layer is preferably formed at a stage when the diameter of the Cu core material is as large as 50 to 500 times the final wire diameter, and it is preferable to form the coating layer on the surface of the large-diameter ingot. This is because by forming the coating layer at a stage when the diameter of the Cu core material is large, the processing degree of the coating layer can be enhanced in the following wire-drawing processing or the like, and refinement of crystal grains is facilitated at the final wire diameter.

As described above, the coating layer may be formed by, for example, providing an alloy layer containing the element B and the element C at a predetermined ratio on the surface of the Cu core material and further providing a layer of the element A thereon (hereinafter, also referred to as "two-stage coating"). The coating layer may also be formed by, for example, providing a layer of the element C on a surface of the Cu core material, providing a layer of the element B thereon, and further providing a layer of the element A thereon (hereinafter, also referred to as "three-stage coating"). Furthermore, the coating layer may be formed by, for example, providing an alloy layer containing the element A, the element B, and the element C at a predetermined ratio on a surface of the Cu core material (hereinafter, also referred to as "one-stage coating"). Hereinafter, an example of a procedure for forming the coating layer by the two-stage coating with Au as the element A and Pd and Ni as the element B and the element C will be shown. That is, the coating layer may be formed by, for example, providing a Pd-Ni alloy layer containing Pd and Ni at a predetermined ratio on a surface of the Cu core material and further providing an Au layer thereon. Herein, from the viewpoint of forming a coating layer with an excellent adhesiveness to the Cu core material, a Pd-Ni alloy layer containing Pd and Ni at a predetermined ratio may be formed by performing strike plating with conductive metal on the surface of the Cu core material. The procedure of coating may be appropriately adjusted. For example, after forming a Pd-Ni alloy layer containing Pd and Ni at a predetermined ratio, a layer containing one or more Pd and Ni (e.g., a Pd layer, an Ni layer, or a Pd-Ni alloy layer) may be further provided, and thereafter an Au layer may be provided thereon.

The wire-drawing process can be performed by using a continuous wire-drawing machine in which a plurality of diamond-coated dies can be set. If necessary, heat treatment may be performed during the wire-drawing process. The constituent elements of the coating layer can be dispersed by a heat treatment to form a region (e.g., an alloy region containing Au, Pd, and Ni) containing three or more elements selected from the group consisting of Pd, Pt, Au, Ni, and Ag in the vicinity of the wire surface so that the condition (2) described above is satisfied. As a method therefor, a method that promotes alloying by continuously sweeping the wire at a constant speed in an electric furnace at a constant furnace temperature is preferable since the composition and thickness of the alloy can be surely controlled.

Hereinafter, regarding an embodiment in which the coating layer is formed on a surface of the Cu core material by electroplating, an example of the preferable aspect will be described from the viewpoint of adjusting the width of crystal grains on the wire surface in the condition (1) described above to a desired range.

In such a preferable aspect, various conditions of electroplating, wire-drawing processing, and a heat treatment are controlled to adjust the width of crystal grains on the wire surface to a desired range.

First, in order to trigger the nucleation of the constituent elements of the coating layer and suppress the growth of crystal grains in the electroplating process, the temperature of the plating bath is preferably 60°C or lower and more preferably 50°C or lower. The lower limit of the temperature of the plating bath is not particularly limited as long as electroplating can be smoothly performed, and can be, for example, 10°C or higher, 15°C or higher, and 20°C or higher. In order to trigger the nucleation of the constituent elements of the coating layer and suppress the growth of crystal grains in the electroplating process, it is preferable to perform a plating treatment by stirring a plating liquid to be in a liquid flowing state. Therefore, in a preferable embodiment, the electroplating process includes performing a plating treatment in a plating bath at 10 to 60°C (more preferably 10 to 50°C) in a liquid flowing state.

Regarding the wire-drawing process and the heat treatment, an intermediate heat treatment is preferably performed during the wire-drawing process when the diameter of the wire is in a range of 5 to 50 times the final wire diameter. This is because by performing an appropriate intermediate heat treatment, the processing strain inside the coating layer is adjusted to facilitate adjustment of the size of crystal grains at a final wire diameter. By performing an appropriate intermediate heat treatment, the constituent elements of the coating layer are dispersed and alloyed thereby to impede recrystallization to facilitate refinement of the size of crystal grains.

In a particularly preferable embodiment, a Cu core material at a stage of having a diameter that is as large as 50 to 500 times the final wire diameter is subjected to an electroplating treatment in a plating bath at 10 to 60°C in a liquid flowing state to form a coating layer on a surface of the Cu core material. Further, it is preferable to perform the wire-drawing process of the wire and perform an intermediate heat treatment during the wire-drawing process when the diameter thereof is in a range of 5 to 50 times the final wire diameter.

The wire of the present invention can achieve a favorable shape stability of the 2nd bonded part. The wire of the present invention can also achieve a favorable bond reliability of the 2nd bonded part even in a rigorous high-temperature environment. Thus, the bonding wire of the present invention can be suitably used as various bonding wires, including bonding wires for on-vehicle devices and power devices.

### [Method for manufacturing semiconductor device]

The semiconductor device can be manufactured by connecting the electrode on the semiconductor chip to the lead frame or the electrode on the circuit board by using the bonding wire for semiconductor devices of the present invention.

In an embodiment, the semiconductor device according to the present invention includes a circuit board, a semiconductor chip, and a bonding wire for electrically connecting the circuit board and the semiconductor chip with each other, and is characterized in that the bonding wire is the wire of the present invention.

In the semiconductor device of the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in JP 2020-150116 A, the semiconductor device may include a lead frame and a semiconductor chip mounted on the lead frame.

Examples of the semiconductor device may include various semiconductor devices used for electric products (for example, a computer, a cellular telephone, a digital camera, a television, an air conditioner, and a solar power generation system), vehicles (for example, a motorcycle, an automobile, an electric train, a ship, and an aircraft), and the like.

### [Examples]

There will be specifically described the present invention with Examples. However, the present invention is not limited to the Examples described below.

### (Sample)

First, the method for preparing a sample will be described. For Cu as a raw material of the Cu core material, Cu having a purity of 99.99% by mass or more (4N) with the balance composed of inevitable impurities was used. In a case of adding the first additive element, the second additive element, or the third additive element, an additive element having a purity of 99% by mass or more with the balance composed of inevitable impurities was used, or alternatively a mother alloy of Cu with a high concentration of these additive elements was used.

For the Cu alloy as the core material, the raw material was first charged into a graphite crucible, and melted by heating to 1090 to 1500°C in an inert atmosphere such as an N₂ gas or Ar gas using a high-frequency furnace. Then, an ingot with a diameter of 4 to 7 mm was obtained by continuous casting. Next, a coating layer was formed on the ingot thus obtained by an electroplating method. For forming the coating layer, an acid washing with hydrochloric acid or sulfuric acid was performed to remove an oxide film on the ingot surface and then performing 2-stage coating (for example, Example Nos. 1, 2, 4, and 5), three-stage coating (for example, Example Nos. 3, 6, and 10), one-stage coating (for example, Example Nos. 7, 12, and 13), or the like. In particular, in Example Nos. 1, 2, 4, 5, and the like based on 2-stage coating, a Pt-Ni alloy layer or a Pd-Ni alloy layer was formed to cover the entire surface of the ingot by using a plating liquid of a Pt-Ni alloy containing Pt and Ni at a predetermined ratio or a plating liquid of a Pd-Ni alloy containing Pd and Ni at a predetermined ratio, and an Au layer was provided on the Pt-Ni alloy layer or the Pd-Ni alloy layer thereof by using an Au plating liquid. In Example Nos. 3, 6, 10, and the like based on three-stage coating, a Pd layer, a Pt layer, or an Ni layer (first layer) was provided to cover the entire surface of the ingot by using a plating liquid of Pd, Pt, or Ni , and a Pd layer, a Pt layer, or an Ni layer (second layer; different from the first layer) was provided on the first layer by using a plating liquid of Pd, Pt, or Ni, an Ag layer or an Au layer (third layer) was provided on the second layer by using a plating liquid of Ag or Au . In Example Nos. 7, 12, 13, and the like based on one-stage coating, a Pt-Ni-Ag alloy layer, an Au-Pd-Ni alloy layer, or an Au-Pt-Ni alloy layer was formed to cover the entire surface of the ingot by using a plating liquid of a Pt-Ni-Ag alloy containing Pt, Ni, and Ag at a predetermined ratio, a plating liquid of an Au-Pd-Ni alloy containing Au, Pd, and Ni at a predetermined ratio, or a plating liquid of an Au-Pt-Ni alloy containing Au, Pt, and Ni at a predetermined ratio so as to. Note that formation of each layer by an electroplating method was performed at a plating bath temperature of 20 to 40°C in a liquid flowing state while stirring the plating liquid.

Thereafter, the ingot was subjected to drawing processing, wire-drawing processing and the like to be processed to have a final wire diameter. In order to control the width of crystal grains in the vicinity of the wire surface, intermediate heat treatment was performed 1 to 2 times as needed during the processing. For the conditions of the intermediate heat treatment when the wire diameter was 0.1 to 0.3 mm, the heat treatment temperature was 200 to 600°C, and the heat treatment time was 1 to 6 seconds. The intermediate heat treatment was performed while continuously sweeping the wire under flowing of an N₂ gas or Ar gas. After the wire was processed to have the final diameter, a refining heat treatment was performed while continuously sweeping the wire under flowing of an N₂ gas or Ar gas. The heat treatment temperature for the refining heat treatment was 200 to 600°C, the wire feeding speed was 20 to 200 m/min, and the heat treatment time was 0.2 to 0.8 seconds. For reducing the width of crystal grains, the heat treatment temperature was set to be lower, or the wire feeding speed was set to be higher. For increasing the width of crystal grains, the heat treatment temperature was set to be higher, or the wire feeding speed was set to be lower.

### (Test and evaluation methods)

There will be described test and evaluation methods.

### [Thickness analysis of coating layer by Auger electron spectroscopy (AES)]

A depth analysis using AES was used for the thickness analysis of the coating layer. The depth analysis using AES analyzes a change in a composition in the depth direction by alternately performing a composition analysis and sputtering, so that a change in concentration of each element in the direction from the surface of the wire toward the depth (center) of the wire (a so-called concentration profile in a depth direction) can be obtained.

First, the bonding wire to be measured was fixed to the sample holder in a linear arrangement. Next, a concentration profile in the depth direction was obtained by performing 1) composition analysis of the wire surface using AES, and then 2) sputtering with Ar and 3) composition analysis of the surface using AES after sputtering and repeating these 2) and 3). The sputtering of 2) was performed with Ar⁺ ions at an acceleration voltage of 2 kV. In the composition analysis of the surface of 1) and 3), the dimensions of the measuring surface and the conditions of the composition analysis using AES were as follows. That is, the measuring surface was determined so that the center of the width of the measuring surface was aligned with the center of the width of the wire in the direction perpendicular to the wire axis, and the width of the measuring surface was 5% or more and 15% or less of the wire diameter. The length of the measuring surface was set to be five times the width of the measuring surface. With using an AES device (PHI-700 manufactured by Ulvac-Phi, Inc.), the composition analysis was performed on the surface of the wire under a condition of acceleration voltage of 10 kV to obtain the concentration (atomic %) of each of the elements of Pd, Pt, Au, Ni, Ag, and Cu. When determining the concentration of each of the elements, a gas component such as carbon (C), sulfur (S), oxygen (O), and nitrogen (N), non-metal elements, and the like was not taken into account.

When a concentration profile in a depth direction is obtained by depth analysis using AES, peaks used for detecting each of the elements of Pd, Pt, Au, Ni, Ag, and Cu were as follows. That is, attention was paid to the energy values of the negative peaks (minimum values) of the respective elements in the Auger electron spectrum, and the peaks of Au (2022 eV), Pd (333 eV), Pt (1969 eV), Ag (359 eV), Ni (849 eV), and Cu (922 eV) were used.

Auger electron spectral analysis and calculation of the concentration were performed using an analysis software (PHI MultiPak) equipped with the AES device. In order to improve the accuracy of the analysis, an LLS treatment was performed as needed. Specifically, a target sample (wire) having a part containing both Cu and Ni was subjected to an LLS treatment when the peaks of Cu and Ni were separated. That is, a target sample was analyzed by obtaining an Auger electron spectrum using pure Cu and pure Ni and performing an LLS treatment using the spectrum as data of a reference sample of an element. When a part containing Cu but no Ni (Cu-containing part) and a part containing Ni but no Cu (Ni-containing part) separately exist in a target sample, the Auger electron spectra of the Cu-containing part and the Ni-containing part were used as data of a reference sample of an element to perform an LLS treatment in the concentration analysis of a Ni element and a Cu element. A target sample containing Au or Pt was subjected to an LLS treatment in order to reduce the background noise. The LLS treatment was performed based on the waveform of the Auger electron spectrum in the vicinity of the peak energy value of Au or Pt described above.

The concentration profile in a depth direction was obtained for the measuring surface at three points which were separated from each other by 1 mm or more in the wire longitudinal direction.

### - Average concentration of each of the elements in region d₀₋₁₀ from surface to depth of 10 nm -

When the concentration profile in a depth direction was obtained using AES, the measurement was performed so that the number of measurement points in a depth direction was 10 or more and 20 or less in the region d₀₋₁₀. The depth to be measured using AES analysis is determined by the product of the sputtering speed and the time. Since the sputtering speed is generally measured using SiO₂ that is a reference sample, the depth analyzed by AES is represented by an SiO₂ equivalent value. In brief, an SiO₂ equivalent value was used as the unit for the thickness of the coating layer. The intervals between measurement points were set to be the same based on such an SiO₂ equivalent value.

Attention was paid to the concentration C_{Pd} (atomic%) of Pd in the obtained concentration profile in a depth direction, and an arithmetic average of the values of C_{Pd} for all measurement points of a region from the wire surface position to a depth position of 10 nm (i.e., region d₀₋₁₀) was obtained to determine the average concentration of Pd in the region d₀₋₁₀. An average concentration of each of the elements of Pt, Au, Ni, and Ag was also determined in the same manner as above by obtaining an arithmetic average of the concentration values of each of the elements for all measurement points of the region d₀₋₁₀.

As the average concentration of each of the elements in the region d₀₋₁₀, an arithmetic average value of the values obtained for three measuring surfaces was adopted.

### - Thickness of coating layer -

In the obtained concentration profile in the depth direction, the concentration profile was confirmed from the wire surface toward the wire center of the wire, and a distance Z1 from the wire surface position Z0 to the depth position where the concentration of Cu as the core material reaches 50 atomic% for the first time was determined as a measured thickness of the coating layer. An arithmetic average value of numerical values obtained for the measuring surfaces at three points was employed as the thickness of the coating layer. Regarding the wire according to the example, it was confirmed that the total number of measurement points in the coating layer was 50 to 100.

Regarding the wire according to the example, it was confirmed that when the thickness of the coating layer is defined as dt in the concentration profile in the depth direction of the wire, the total concentration of elements selected from the group consisting of Pd, Pt, Au, Ni, and Ag in the position of depth dt from the wire surface, i.e., at the boundary between the coating layer and the Cu core material, was 45 atomic% or more. Regarding the wire according to example, it was confirmed that when the thickness of the coating layer is defined as dt in the concentration profile in the depth direction of the wire, the total concentration of elements selected from the group consisting of Pd, Pt, Au, Ni, and Ag in the position of depth 0.5dt from the wire surface was 90 atomic% or more.

### [Crystal analysis of wire surface by electron backscattered diffraction (EBSD) method]

Crystal analysis of the wire surface was performed by an EBSD method with the surface of the wire as a measuring surface.

### - Width of crystal grains on wire surface -

First, the bonding wire to be measured was fixed to the sample holder in a linear arrangement. Next, the measuring surface was determined so that the center of the width of the wire in a direction perpendicular to the wire axis (in the wire circumferential direction) was aligned with the center of the width of the measuring surface, and that the measuring surface had the width of 7 µm and the length of 15 µm. With using an AES measuring device (SU-70 manufactured by Hitachi High-Technologies Corporation), the measurement was performed at a measurement magnification of x15,000 and an interval between measurement points of 0.03 µm. In the measurement, the acceleration voltage was optimized within a range of 15 to 30 kV depending on the surface state of the sample. Next, with using the analysis software (OIM analysis manufactured by TSL Solutions) contained in the EBSD measuring device, the analysis was performed excluding measurement points having a CI (Confidence Index) values of less than 0.1, and the average size in the wire circumferential direction of crystal grains, i.e., the width (nm) of crystal grains, was determined by taking as a crystal grain boundary at which an orientation difference between adjacent measurement points is 5 degrees or more and setting the lower limit number of pixels (equivalent to the Minimum size in item Grain Size in the setting of the device-attached software) recognized as crystal grains to a value of 2 to **5.** In the analysis, the crystal data of the element having the highest average concentration in the coating layer were used.

The calculation of the width of crystal grains on the wire surface by the analysis software is performed by (i) drawing a line in the width direction (wire circumferential direction) of the measuring surface, determining the size of each crystal grain in the wire circumferential direction on the basis of an interval of the crystal grain boundaries on the line, and (ii) calculating the average size of the crystal grains in the wire circumferential direction by arithmetically averaging the sizes of respective crystal grains in the wire circumferential direction. A plurality of lines (N = 20 to 50) spaced apart from one another in the wire longitudinal direction were used for the calculation, and an average value thereof was adopted. Note that the analysis software automatically sets the lines at an equal interval by setting the number N of lines.

### - Crystal orientation of wire surface -

In the same manner as above, the bonding wire to be measured was fixed to the sample holder, and a measuring surface was determined. Then, the crystal orientation on the measuring surface was observed to determine the proportion of a <111> crystal orientation angled at 15 degrees or less to the wire longitudinal direction in the crystal orientations in the wire longitudinal direction.

The measurement of a crystal orientation using an EBSD method was performed on the measuring surfaces at three points which were separated from each other by 1 mm or more in the wire longitudinal direction, and an average value thereof was employed.

### [Measurement of element content]

The contents of the first additive element, the second additive element, and the third additive element in the wire were detected as the concentration of elements contained in the entire wire by analyzing a liquid in which the bonding wire was dissolved with a strong acid using an ICP emission spectrometer or an ICP mass spectrometer. As an analysis device, ICP-OES ("PS3520UVDDII" manufactured by Hitachi High-Tech Corporation) or ICP-MS ("Agilent 7700x ICP-MS" manufactured by Agilent Technologies, Inc.) was used.

### [Shape stability of 2nd bonded part]

A sample for testing the shape stability of the 2nd bonded part was manufactured by performing wedge bonding onto leads of a lead frame using a commercially available wire bonder. An Fe-42 atomic% Ni alloy lead frame plated with 1 to 3 µm Ag was used as the lead frame, and bonding was performed at a stage temperature of 200°C under a flow of an N₂ + 5%H₂ gas at a flow rate of 0.5 L/min.

### - Bonding shape (symmetry of fish tail shape) -

Regarding the bonding shape of the 2nd bonded part, the symmetry of the fish tail shape was evaluated by observing 2000 of the 2nd bonded parts randomly selected in the sample for testing the shape stability of the 2nd bonded part. Specifically, the 2nd bonded part in which the fish tail shape was unsymmetrical to the axis of the wire or peeling occurred were counted as failure, and evaluation was performed in accordance with the following criteria.

### Evaluation criteria:

⊚ (very excellent): 1 or less failure
⊚ (excellent): 2 to 4 failures
○ (good): 5 to 9 failures
× (poor): 10 or more failures

### - Bonding width (stability of deformation width of fish tail shape) -

Regarding the bonding width of the 2nd bonded part, 2000 of the 2nd bonded part randomly selected in the sample for testing the shape stability of the 2nd bonded part were observed, and a standard deviation of the deformation width of the fish tail shape in the direction perpendicular to the axis of the wire was determined and evaluated in accordance with the following criteria.

### Evaluation criteria:

⊚(excellent): The 3σ is less than 5 µm.
○ (good): The 3σ is 5 µm or more to less than 15 µm.
× (poor): The 3σ is 15 µm or more.

### [Bond reliability of 2nd bonded part]

The bond reliability of the 2nd bonded part was evaluated by a High Temperature Storage Life Test (HTSL).

A sample was prepared by performing wedge bonding onto leads of a lead frame using a commercially available wire bonder. The resultant sample was sealed by a commercially available thermosetting epoxy resin to manufacture a sample for testing the bond reliability of the 2nd bonded part. An Fe-42 atomic% Ni alloy lead frame plated with 1 to 3 µm Ag was used as the lead frame, and bonding was performed at a stage temperature of 200°C under a flow of an N₂ + 5%H₂ gas at a flow rate of 0.5 L/min. The manufactured sample for testing the bond reliability of the 2nd bonded part was exposed to a high-temperature environment with a temperature of 180°C using a high-temperature thermostatic device. The pull test on the wedge bonded part was performed every 500 hours, and a time until a value of pull force became half of the initial pull force was determined to be the bonding life of the 2nd bonded part. An arithmetic average value of measurement values of 50 wedge bonded parts randomly selected was used for the value of the pull force. The pull test after the High Temperature Storage Life Test was performed after removing the resin by acid treatment, and exposing the wedge bonded part. Evaluation was then performed in accordance with the following criteria.

### Evaluation criteria:

⊚⊚ (very excellent): Bonding life of 2000 hours or more.
⊚ (excellent): Bonding life of 1000 hours or more and less than 2000 hours.
○ (good): Bonding life of 500 hours or more and less than 1000 hours.
× (poor): Bonding life of less than 500 hours.

### [Bond reliability of 1st bonded part]

The bond reliability of the 1st bonded part was evaluated by both of a Highly Accelerated Temperature and Humidity Stress Test (HAST) and a High Temperature Storage Life Test (HTSL).

### - HAST -

A sample was prepared by performing ball bonding, using a commercially available wire bonder, on an electrode that was disposed by depositing an Al-1.0 mass% Si-0.5 mass% Cu alloy having a thickness of 1.5 µm on a silicon substrate on a general metal frame. The resultant sample was sealed by a commercially available thermosetting epoxy resin to manufacture a sample for testing the bond reliability of the 1st bonded part. The ball was formed with a current value of 30 to 75 mA, an EFO gap of 762 µm, and a tail length of 254 µm while flowing of an N₂ + 5% H₂ gas at a flow rate of 0.4 to 0.6 L/min. The diameter of the ball was in a range of 1.5 to 1.9 times the wire diameter. The produced sample for testing the bond reliability of the 1st bonded part was exposed to a high-temperature and high-humidity environment with a temperature of 130°C and a relative humidity of 85% using an unsaturated type pressure cooker tester and was biased with 7 V. The shear test on the ball bonded part was performed every 48 hours, and a time until a value of shear force became half of the initial shear force was determined to be the bonding life of the 1st bonded part. An arithmetic average value of measurement values of 50 ball bonded parts randomly selected was used for the value of the shear force. The shear test was performed after removing the resin by acid treatment, and exposing the ball bonded part. Evaluation was then performed in accordance with the following criteria.

### Evaluation criteria:

⊚ (excellent): Bonding life of 384 hours or more.
○ (good): Bonding life of 240 hours or more and less than 384 hours.
× (poor): Bonding life of less than 240 hours.

### - HTSL -

A sample for testing the bond reliability of the 1st bonded part manufactured by the same procedure as that described above was exposed to an environment with a temperature of 175°C using a high-temperature thermostatic device. The shear test on the ball bonded part was performed every 500 hours, and a time until the value of shear force became half of the initial shear force was determined to be the bonding life of the 1st bonded part. An arithmetic average value of measurement values of 50 ball bonded parts randomly selected was used for the value of the shear force. The shear test after the High Temperature Storage Life test was performed after removing the resin by acid treatment, and exposing the ball bonded part. Evaluation was then performed in accordance with the following criteria.

### Evaluation criteria:

⊚ (excellent): Bonding life of 2000 hours or more.
○ (good): Bonding life of 1000 hours or more and less than 2000 hours.
× (poor): Bonding life of less than 1000 hours.

### [Loop shape]

Regarding loop shape stability (reproducibility of a loop profile), 30 trapezoid loops were connected to have a loop length of 2 mm, a height difference of the bonded part of 250 µm, and a loop height of 200 µm, and evaluation was performed based on the standard deviation of the maximum loop height. An optical microscope was used for measuring the height, and evaluation was performed in accordance with the following criteria.

### Evaluation criteria:

⊚ (excellent): The 3σ is less than 20 µm.
○ (good): The 3σ is 20 µm or more to less than 30 µm.
× (poor): The 30 is 30 µm or more.

### [Compression-bonding shape]

The evaluation of the compression-bonding shape of the 1st bonded part (the crushed shape of the ball) was carried out by forming a ball using a commercially available wire bonder under the conditions described in the section [Bond reliability of 1st bonded part] noted above, compression-bonding the ball onto an electrode that had been formed by depositing an Al-1.0 mass% Si-0.5 mass% Cu alloy film having a thickness of 1.5 µm on a Si substrate, and observing the bonded part from directly above by an optical microscope (the number of evaluations N = 100). In the evaluation of the crushed shape of ball, a case in which a crushed shape was close to true circle was determined to be favorable, and a case in which a crushed shape was an oval shape or a petal shape was determined to be failure. Evaluation was then performed in accordance with the following criteria.

### Evaluation criteria:

⊚ (excellent): 0 failure
○ (good): 1 to 3 failures (no problem for practical use)
△ (fair): 4 or 5 failures (no problem for practical use)
× (poor): 6 or more failures

### [Chip damage]

The evaluation of the chip damage was carried out by forming a ball using a commercially available wire bonder under the conditions described in the section [Bond reliability of 1st bonded part] noted above, compression-bonding the ball onto an electrode that had been formed by depositing an Al-1.0 mass% Si-0.5 mass% Cu alloy film having a thickness of 1.5 µm on an Si substrate, dissolving the wire and the electrode with a chemical solution to expose the Si substrate, and observing the Si substrate directly below the bonded part by an optical microscope (the number of evaluations N = 50). Evaluation was then performed in accordance with the following criteria.

### Evaluation criteria:

⊚ (excellent): No crack or bonding traces
○ (good): No crack, but there are parts where bonding traces were confirmed (three or less parts)
× (poor): All others

The evaluation results of Examples and Comparative Examples are shown in Tables 1 and 2.

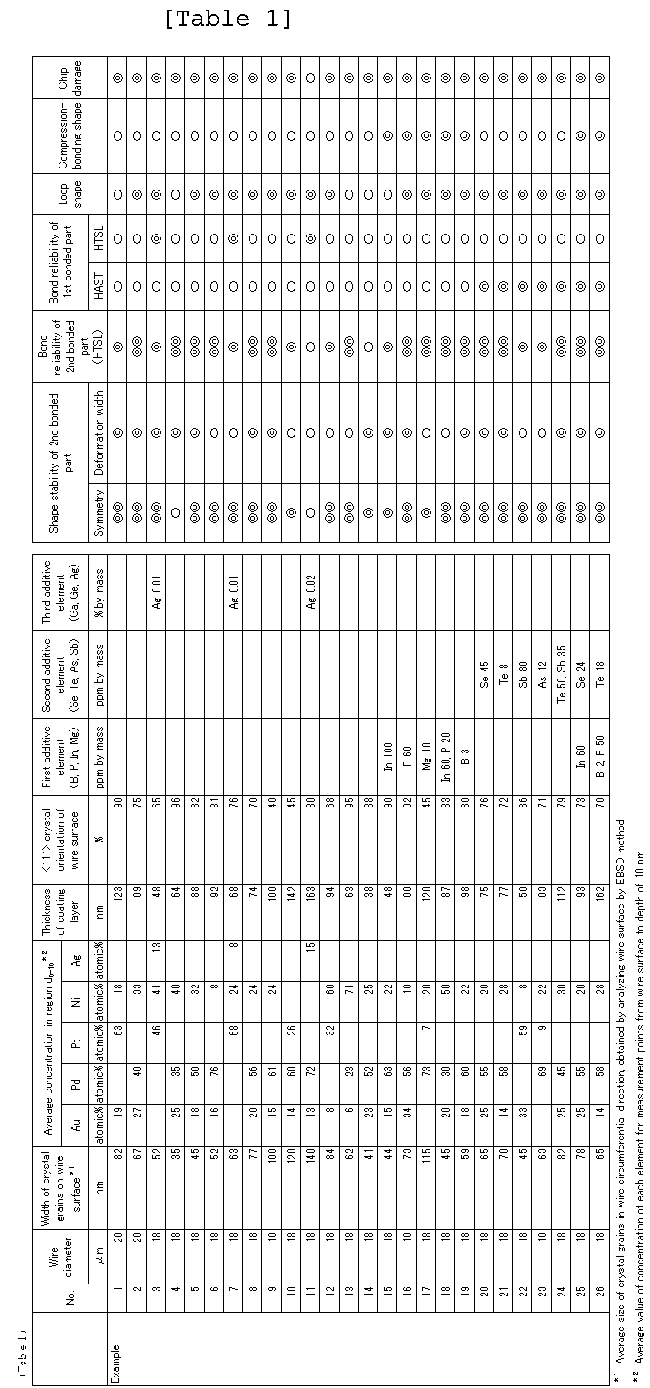

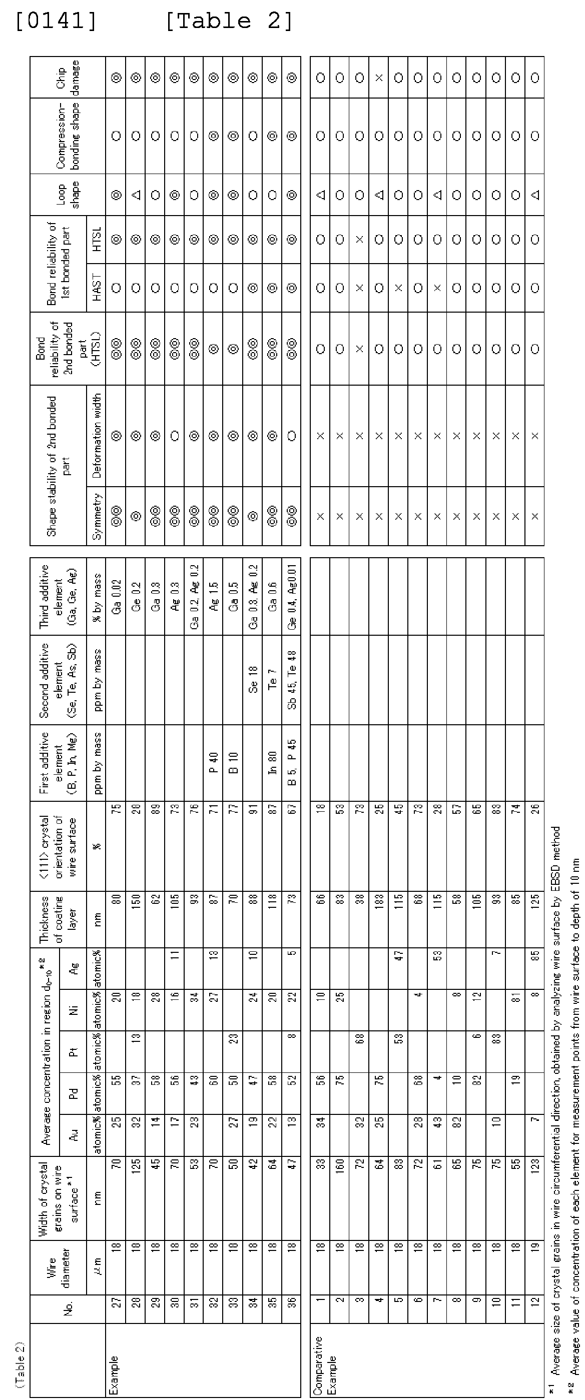

All of the wires of Example Nos. 1 to 36 included the coating layer that satisfied the conditions (1) and (2) specified this specification, and it was confirmed that they achieved a favorable symmetry of the fish tail shape and, a fish tail shape in which the deformation width in a perpendicular direction to the axis of the wire only fluctuated minutely, and achieved a favorable shape stability of the 2nd bonded part. Furthermore, it was confirmed that a favorable bond reliability of the 2nd bonded part was achieved even in a rigorous high-temperature environment with a temperature of 180°C.

It was also confirmed that the wires of Example Nos. 1 to 13 and 15 to 36 including the coating layer with a thickness of 40 nm or more to 200 nm or less, specifically, the wires including the coating layer with a thickness in a preferable range of 50 nm or more to 150 nm or less, easily exhibited particularly favorable bond reliability of the 2nd bonded part in a rigorous high-temperature environment.

Additionally, in the results of the measurement of the crystal orientation on the surface of the wire by the EBSD method, it was confirmed that all of the wires of Example Nos. 1 to 3, 5 to 27, and 29 to 36, in which the proportion of a <111> crystal orientation angled at 15 degrees or less to the longitudinal direction of the wire was equal to or higher than 30% and equal to or lower than 95%, achieved a favorable loop shape. Specifically, it was confirmed that the wires of Example Nos. 2, 3, 5 to 10, 12, 16 to 21, 23 to 27, 30 to 33, and 36, in which the proportion of the <111> crystal orientation was in a preferable range of equal to higher than 40% and equal to lower than 85%, easily achieved a further favorable loop shape.

In addition, it was confirmed that the wires of Example Nos. 15 to 19, 25, 26, 32, 33, 35, and 36, in which the total content of the first additive element was 1 ppm by mass or more, achieved a particularly favorable compression-bonding shape of the 1st bonded part. It was confirmed that the wires of Example Nos. 20 to 26 and 34 to 36, in which the total content of the second additive element was 1 ppm by mass or more, achieved a further favorable bond reliability of the 1st bonded part in a high-temperature and high-humidity environment. It was confirmed that the wires of Example Nos. 3, 7, 11, and 27 to 36, in which the total content of the third additive element was 0.011 mass% or more, achieved a further favorable bond reliability of the 1st bonded part in a high-temperature environment.

On the other hand, it was confirmed that the wires of Comparative Example Nos.1 to 12 included a coating layer that did not satisfy at least one of the conditions (1) and (2) specified in this specification and had a poor shape stability of the 2nd bonded part.

### REFERENCE SIGNS LIST

- 1: bonding wire (wire)
- 2: measuring surface
- 10: 2nd bonded part
- 10w: deformation width of 2nd bonded part (deformation width in a direction perpendicular to a wire axis)
- X: axis of wire (center of width of wire)
- W: width of wire (wire diameter)
- wₐ: width of measuring surface
- lₐ: length of measuring surface

## Claims

1. A bonding wire for semiconductor devices, the bonding wire comprising: a core material of Cu or a Cu alloy; and a coating layer containing a conductive metal other than Cu formed on a surface of the core material, wherein
an average size of crystal grains in a wire circumferential direction, obtained by analyzing a surface of the wire by an electron backscattered diffraction (EBSD) method, is 35 nm or more and 140 nm or less, and
three or more elements selected from the group consisting of Pd, Pt, Au, Ni, and Ag are contained in a region (hereinafter, referred to as a "region d₀₋₁₀") from the surface to a depth of 10 nm in a concentration profile in a depth direction of the wire obtained by measurement using Auger electron spectroscopy (AES), and concentration conditions (i) and (ii) below are satisfied:
(i) for at least three elements out of the three or more elements contained in the region d₀₋₁₀, each element have an average concentration in the region d₀₋₁₀ of 5 atomic% or more, and
(ii) for all elements out of the three or more elements contained in the region d₀₋₁₀, each element have an average concentration in the region d₀₋₁₀ of 80 atomic% or less.

2. The bonding wire according to claim 1, wherein a thickness of the coating layer is 40 nm or more and 200 nm or less.

3. The bonding wire according to claim 1 or 2, wherein a proportion of a <111> crystal orientation angled at 15 degrees or less to a longitudinal direction of the wire is equal to or higher than 30% and equal to or lower than 95% in results of measurement of the crystal orientation on the surface of the wire by the EBSD method.

4. The bonding wire according to any one of claims 1 to 3, wherein the concentration profile in the depth direction of the wire is obtained by performing the measurement using AES under the following <Condition> while digging down the wire from its surface in the depth direction by Ar sputtering:
<Condition> a center of width of the measuring surface is aligned with a center of width of the wire, the width of the measuring surface is 5% or more and 15% or less of a diameter of the wire, and a length of the measuring surface is five times the width of the measuring surface.

5. The bonding wire according to any one of claims 1 to 4, wherein the bonding wire contains one or more elements selected from the group consisting of B, P, In, and Mg (hereinafter, referred to as a "first additive element"), and a total concentration of the first additive element is 1 ppm by mass or more and 100 ppm by mass or less relative to the entire wire.

6. The bonding wire according to any one of claims 1 to 5, wherein the bonding wire contains one or more elements selected from the group consisting of Se, Te, As, and Sb (hereinafter, referred to as a "second additive element"), and a total concentration of the second additive element is 1 ppm by mass or more and 100 ppm by mass or less relative to the entire wire.

7. The bonding wire according to any one of claims 1 to 6, wherein the bonding wire contains one or more elements selected from the group consisting of Ga, Ge, and Ag (hereinafter, referred to as a "third additive element"), and a total concentration of the third additive element is 0.011% by mass or more and 1.5% by mass or less relative to the entire wire.

8. A semiconductor device comprising the bonding wire according to any one of claims 1 to 7.
